# FASCICULE DE BREVET EUROPEEN

(11) **EP 0 445 886 B1**
(45) Date de publication et mention de la délivrance du brevet: **04.01.1995**
(21) Numéro de dépôt: 91200458.7
(22) Date de dépôt: 04.03.1991
(51) Int. Cl.: H03D 3/00, H04N 7/04

(54) **Récepteur de télévision muni d'un démodulateur de fréquences à abaissement de seuil**
Fernsehempfänger mit einem FM Demodulator mit reduziertem Schwellwert
Television receiver with reduced threshold level frequency demodulator

(30) Priorité: 09.03.1990 FR 9003024
(43) Date de publication de la demande: 11.09.1991
(73) Titulaire: PHILIPS ELECTRONIQUE GRAND PUBLIC, 92150 Suresnes (FR); Philips Electronics N.V., 5621 BA Eindhoven (NL)
(72) Inventeur: Egger, Jean, F-75008 Paris (FR)
(74) Mandataire: Caron, Jean

(56) Documents cités:
- EP-A- 0 086 838
- WO-A-85/03399
- WO-A-86/03919

## Description

La présente invention concerne un récepteur de télévision bistandard pour des signaux modulés en fréquence soit selon un premier standard dans lequel une sous-porteuse couleur est multiplexée en fréquence (parexemple PAL, NTSC, SECAM), soit selon un deuxième standard dans lequel les signaux sont à multiplexage temporel (par exemple MAC), avec un dispositif démodulateur comportant en amont du démodulateur de fréquences proprement dit un filtre passe-bande à fréquence centrale accordable asservie à la fréquence du signal d'entrée au moyen d'une rétroaction ramenant le signal démodulé issu du démodulateur à l'entrée de réglage d'accord dudit filtre, ceci étant produit dans le susdit premier standard via une première boucle comportant un filtre passe-bas, en parallèle avec une deuxième boucle comportant un filtre passe-bande accordé pratiquement sur la fréquence de sous-porteuse couleur, avec un additionneur pour additionner les signaux issus de chacune des deux boucles et les appliquer à l'entrée de réglage d'accord du filtre à fréquence centrale accordable.

L'invention s'applique notamment en télévision par satellite, pour la démodulation d'un signal à fréquence intermédiaire dans la gamme de fréquences 400-700 Mhz, où peuvent se présenter aussi bien des signaux en standard PAL qu'en standard MAC.

Il convient d'éviter l'apparition, dans le signal FM démodulé, de parasites appelés "clicks". On sait que de tels parasites se produisent en présence de bruit lorsque ce dernier est assez puissant pour entraîner un saut de phase de plus de 180° du signal d'entrée du démodulateur. Le signal démodulé est d'autant plus perturbé que le signal utile à l'entrée est faible. On appelle seuil le rapport porteuse à bruit à l'entrée, mesuré dans une bande de bruit de référence, pour lequel les clicks disparaissent. Il existe un seuil statique (c'est-à-dire mesuré avec un signal modulant continu : image blanche) et un seuil dynamique (c'est-à-dire mesuré avec un signal modulant variable: mire de barres couleur par exemple) : ce dernier est plus difficile à abaisser que le seuil statique. Lorsqu'on citera dans la suite des valeurs de seuil, il s'agira toujours de seuils dynamiques.

Pour éviter les clicks, il est connu de réduire la bande passante avant le démodulateur au moyen d'un filtre, ou bien d'utiliser un démodulateur dont les caractéristiques sont choisies de façon qu'il ne puisse pas suivre les sauts de phase, ou encore d'insérer un filtre asservi à la fréquence du signal.

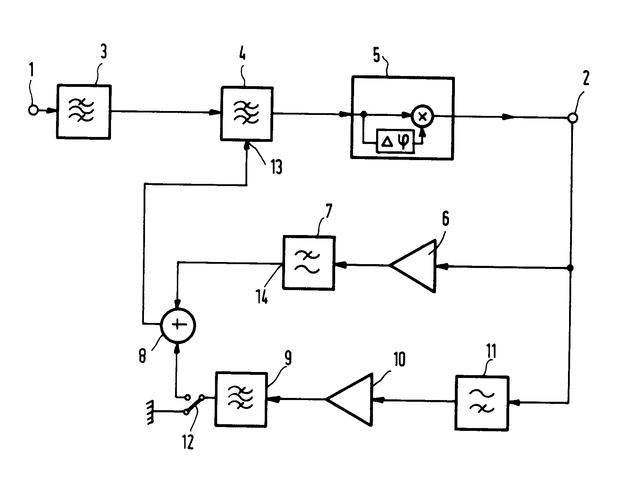

Un démodulateur qui utilise cette dernière méthode est connu du document WO-A-86/03919. Selon ce document, deux schémas synoptiques différents (figure 3 et figure 4) doivent être utilisés selon que la réception se fait selon la norme NTSC ou selon la norme MAC. En outre un élément à retard d'une ligne doit être utilisé pour retrouver des informations en phase.

Le but de l'invention est l'abaissemnt du seuil dynamique dans tous les standards et notamment en réception PAL, et ceci avec les moyens les plus simples et économiques possibles, notamment pour une application à des téléviseurs de grande diffusion.

A cet effet, le récepteur de télévision selon l'invention est remarquable en ce que le filtre passe-bas de la première boucle est le seul élément à déphasage de cette boucle et, pour adapter le téléviseur au susdit deuxième standard, le dispositif est simplement muni d'un interrupteur pour mettre hors service la deuxième boucle.

L'abaissement du seuil obtenu avec ce dispositif très simple est de trois décibels en PAL25Mhz, ce qui est le meilleur résultat obtenu jusqu'à présent. C'est dans ce standard que l'amélioration est la plus forte, et en MAC l'abaissement du seuil est comparable à celui obtenu par les autres démodulateurs à abaissement du seuil connus. En outre ceci est obtenu avec un synoptique commun aux deux normes PAL et MAC, avec un unique interrupteur pour passer d'une norme à l'autre.

Dans une variante de réalisation on utilise, en série avec le filtre passe-bande accordé pratiquement sur la fréquence de la sous-porteuse couleur, un filtre passe-haut.

Dans un autre mode de réalisation, le filtre passe-bande accordé pratiquement sur la fréquence de sous-porteuse couleur est accordé plus précisément sur une fréquence qui présente un léger décalage par rapport à la fréquence de la sous-porteuse couleur, ledit léger décalage étant tel qu'il introduise à la fréquence de la sous-porteuse couleur un déphasage en avance égal à celui qui serait produit par un filtre passe-haut en série.

La description du mode préféré de réalisation qui va suivre, en regard du dessin annexé décrivant un exemple non limitatif fera bien comprendre comment l'invention peut être réalisée.

La figure unique est un schéma-bloc du dispositif démodulateur d'un téléviseur selon l'invention.

Un signal modulé en fréquence en provenance d'un satellite est d'abord amplifié et sa fréquence est transposée dans le récepteur de télévision, puis il est amené à l'entrée 1 du dispositif démodulateur de ce récepteur, représenté sur la figure. Il traverse deux filtres passe-bande en cascade 3 et 4, et parvient au démodulateur proprement dit 5, qui est de préférence un démodulateur de type bien connu à circuit de quadrature et multiplieur. Pour ce démodulateur, on peut utiliser par exemple un circuit intégré du type SL 1452 (Plessey). Néanmoins, le démodulateur 5 pourrait aussi être d'un autre type connu. Le signal démodulé produit par le démodulateur 5 est fourni en sortie sur la borne 2, pour être traité de manière connue dans le téléviseur, et y produire une image.

Pour abaisser le seuil d'apparition des clicks, on connait au moins trois méthodes :
- selon une première méthode, on peut réduire la largeur de bande du filtre 3, ce qui a l'inconvénient d'introduire un risque de troncature du signal avec production d'une distorsion importante. Le seuil dépend de la largeur de bande de ce filtre et de la forme de la fonction de transfert amplitude/fréquence, et aussi du type de modulation du signal : par exemple le seuil n'est pas le même selon que le signal reçu est du type PAL ou du type MAC (il s'agit ici du PAL destiné à la transmission par satellite). En outre il y a trois sortes de PAL (satellite), avec des excursions de fréquence différentes, à savoir 16, 20, ou 25Mhz. Avec cette méthode, on utilise un filtre de largeur 14 Mhz en MAC et de largeur30 Mhzen PAL25Mhz (qui est parmi les trois sortes de PAL celui qui pose le problème le plus difficile), et on arrive à gagner environ un décibel par rapport à un circuit de référence muni d'un filtre de largeur standard.
- selon une deuxième méthode, employée lorsque le démodulateur est de type PLL, on peut ajuster les paramètres de la boucle d'asservissement du PLL pour que ce dernier décroche lors des sauts de phase du signal d'entrée. Il se produit encore un signal parasite traduisant la tentative avortée du circuit pour suivre le saut de phase, mais ce signal peut être atténué par filtrage en sortie du démodulateur. Avec cette méthode, on arrive à gagner environ un décibel en PAL 25 MHz et 2 à 3 décibels en MAC, comme avec la méthode précédente, et la bande passante est un peu meilleure dans le cas du MAC.
- la troisième méthode enfin utilise un filtre étroit mais dont la fréquence d'accord suit celle du signal : c'est la méthode choisie ici et que l'invention se propose d'améliorer.

Dans le dispositif selon l'invention, on utilise un filtre 3 en amont du démodulateur comme avec la première méthode, mais ce filtre a une largeur de bande standard, et on y ajoute un deuxième filtre 4, dont la largeur de bande est étroite de façon à bien limiter le bruit en sortie. Dans l'application à un récepteur bistandard D2-MAC/PAL (satellite), le filtre 3 est accordé sur 479,5 MHz et a une largeur de bande de 37 MHz et le filtre 4 a une largeur de bande de 14 MHz. La troncature du signal utile est évitée du fait que la fréquence centrale du filtre 4 est variable et suit celle du signal utile. La variabilité de la fréquence centrale est obtenue par exemple en utilisant de façon connue comme capacités d'accord du filtre 4 des diodes à capacité variable dites "varicap" dont la valeur de capacité est déterminée par la tension appliquée sur l'entrée de commande de fréquence d'accord 13.

Cette entrée 13 de commande de fréquence d'accord est pilotée par un signal de rétroaction obtenu à partir du signal démodulé fourni sur la borne 2.

Une boucle de rétroaction comporte un amplificateur 6 pour ajuster le niveau du signal de rétroaction, afin que la variation de la fréquence d'accord du filtre suive aussi exactement que possible celle de la fréquence du signal d'entrée. Toutefois un suivi parfait est impossible, et c'est pourquoi un filtre passe-bas 7 est inséré dans la boucle, afin d'établir un compromis entre la part de signal et la part de bruit qui sont réinjectés par la boucle. Pour un fonctionnement optimal il importe qu'il y ait le moins possible de perturbations dans la phase, c'est-à-dire que d'autres éléments que le filtre 7 ne doivent surtout pas être introduits dans cette boucle.

Plus la fréquence du signal modulant augmente, plus l'erreur d'asservissement augmente pour un temps donné de retard de groupe de la boucle. Ainsi la bande passante est d'autant plus faible que le retard de groupe est plus grand. Or la densité spectrale de puissance du signal modulé est différente avec le MAC et avec le PAL. Le filtre 4 ne peut pas être optimisé dans les deux cas. On peut alors penser à introduire une commutation au niveau du filtre 4 pour l'adapter selon le standard : ceci est difficile car les différences sont importantes entre les caractéristiques des filtres adaptés à l'un et à l'autre standard. On peut aussi penser à disposer deux boucles et à choisir soit l'une soit l'autre selon le standard. L'invention est basée sur la constatation qu'en fait la solution la meilleure consiste à utiliser deux boucles ensemble, c'est-à-dire conserver en PAL la boucle optimisée pour le MAC et y ajouter une seconde boucle.

Ainsi le dispositif est muni d'une deuxième boucle qui comporte en cascade à partir de la borne 2 un filtre passe-haut 11, un amplificateur 10 pour ajuster le niveau de rétroaction, et un filtre passe-bande 9. Bien entendu l'ordre de succession de ces différents éléments dans la boucle est indifférent.

Le signal à la sortie 14 de la boucle 6, 7 est amené à un additionneur 8 pour être additionné au signal fourni par l'autre boucle 9, 10, 11 et c'est le signal somme issu de cet additionneur 8 qui est amené à l'entrée 13 de commande de fréquence d'accord pour faire varier dynamiquement la fréquence d'accord du filtre 4.

La boucle 6, 7 joue un rôle principal lorsque l'excursion de fréquence est faible, c'est-à-dire en MAC ou en PAL noir et blanc, et la boucle 9, 10, 11 en quelque sorte relaie la première au voisinage de la sous-porteuse couleur PAL. Le filtre passe-bande 9 a pour fréquence centrale celle de ladite sous porteuse (4,43 MHz). Il joue un rôle analogue à celui du filtre passe-bas 7 : il s'agit d'établir un compromis entre la part de signal et la part de bruit qui sont réinjectés par la boucle. Le filtre passe-haut 11 corrige la phase dans la région de ladite sous-porteuse.

Pour simplifier encore la réalisation du dispositif, il est possible en pratique de supprimer le filtre passe-haut 11 (la deuxième boucle comporte alors les seuls éléments 9 et 10), car pour réaliser la correction de phase apportée par ce filtre passe-haut, on a découvert qu'il suffit de décaler légèrement l'accord du filtre passe-bande par rapport à la fréquence de la sous-porteuse couleur PAL de manière à introduire à cette dernière fréquence un déphasage en avance, qui produit sur la phase le même effet que le filtre passe-haut en série.

Un interrupteur 12 est prévu à la sortie de la boucle 9, 10, (et éventuellement 11), et permet de la mettre hors circuit.

Le fait de conserver en permanence en service la boucle munie du filtre passe-bas 7 offre l'avantage de transmettre la composante continue, ce qui s'avère nécessaire.

Avec un récepteur bistandard PAL/MAC, l'interrupteur 12 est fermé dans le cas du PAL, c'est-à-dire que la boucle 9, 10, 11 est en service, et il est ouvert dans le cas du MAC.

Lorsque l'interrupteur 12 est ouvert, le signal sortant de la deuxième boucle de rétroaction 9, 10, 11 peut être mis à la masse comme le montre la figure.

Pour que le dispositif présente les qualités optimales il est avantageux que les éléments aient les caractéristiques suivantes :
* Filtre passe-bande 3 :
   - passe-bas équivalent ayant plus de trois pôles (on appelle passe-bas équivalent le filtre dont la courbe de réponse serait obtenue en déplaçant celle du filtre passe-bande jusqu'à amener sa fréquence centrale sur zéro).
   - centré sur la fréquence intermédiaire utilisée (par exemple 479,5 MHz).
   - bande passante à 3 db : entre 27 et 37 MHz.
* Filtre accordable 4 :
   - passe-bas équivalent ayant un seul pôle.
   - centré (en l'absence de modulation de la porteuse) sur la fréquence intermédiaire utilisée (par exemple 479,5 MHz).
   - bande passante à 3 db : de 11 à 14 MHz. - distorsion minimale à 14 MHz.
* Filtre passe-haut 11 :
   - si le retard introduit dans la boucle par les éléments 4, 5, 10, 9 est appelé "T", le filtre 11 doit apporter, au voisinage de la sous-porteuse couleur, un déphasage de 2 x pi x T x FSP, où "FSP" est la fréquence de sous-porteuse (pi=3,14159).
* Filtre passe-bande 9 :
   - passe-bas équivalent ayant un seul pôle.
   - centré sur la fréquence de la sous-porteuse couleur.
   - bande passante à 3 db : 2,5 MHz, +/- 0,5 MHz.

## Revendications

1. Récepteur de télévision bistandard pour des signaux modulés en fréquence, soit selon un premier standard avec une sous-porteuse couleur multiplexée en fréquence, soit selon un deuxième standard dans lequel les signaux sont à multiplexage temporel, muni d'un dispositif démodulateur comportant, en amont d'un démodulateur de fréquences proprement dit, un filtre passe-bande à fréquence centrale accordable asservie à la fréquence du signal d'entrée au moyen d'une rétroaction ramenant le signal démodulé issu du démodulateur de fréquences à l'entrée de réglage d'accord dudit filtre, ceci étant produit dans le susdit premier standard via une première boucle comportant un filtre passe-bas, en parallèle avec une deuxième boucle comportant un filtre passe-bande accordé pratiquement sur la fréquence de sous-porteuse couleur, avec un additionneur pour additionner les signaux issus de chacune des deux boucles et les appliquera l'entrée de réglage d'accord du filtre à fréquence centrale accordable, caractérisé en ce que le filtre passe-bas de la première boucle est le seul élément à déphasage de cette boucle et en ce que, pour adapter le téléviseur au susdit deuxième standard, le dispositif est muni d'un interrupteur pour mettre hors service la deuxième boucle.

2. Récepteur de télévision selon la revendication 1, caractérisé en ce qu'il comporte, en série avec le filtre passe-bande accordé pratiquement sur la fréquence de la sous-porteuse couleur, un filtre passe-haut.

3. Récepteur de télévision selon la revendication précédente, caractérisé en ce que le filtre passe-haut apporte, au voisinage de la sous-porteuse couleur, un déphasage de 2 x pi x T x FSP, où "FSP" est la fréquence de sous-porteuse, et "T" est le retard introduit dans la boucle par les éléments de la deuxième boucle.

4. Récepteur de télévision selon la revendication 1, caractérisé en ce que le filtre passe-bande accordé pratiquement sur la fréquence de sous-porteuse couleur est, plus précisément, accordé sur une fréquence qui présente un léger décalage par rapport à la fréquence de la sous-porteuse couleur, ledit léger décalage étant tel qu'il introduit à la fréquence de la sous-porteuse couleur PAL un déphasage en avance égal à celui qui serait produit par un filtre passe-haut en série.

5. Récepteur de télévision selon l'une quelconque des revendications précédentes, caractérisé en ce que le filtre à fréquence centrale accordable a un filtre passe-bas équivalent ayant un seul pôle, est centré (en l'absence de modulation de la porteuse) sur la fréquence intermédiaire utilisée, et a une bande passante à 3 db comprise entre 11 et 14 MHz.

6. Récepteur de télévision selon l'une quelconque des revendications précédentes, caractérisé en ce que le filtre passe-bande à fréquence de sous-porteuse couleur a un filtre passe-bas équivalent ayant un seul pôle, est centré sur la fréquence de la sous-porteuse couleur, et a une bande passante à 3 db comprise entre 2 et 3 MHZ.

7. Récepteur de télévision selon l'une quelconque des revendications précédentes, caractérisé en ce qu'il comporte en amont du filtre passe-bande à fréquence centrale accordable un autre filtre passe-bande fixe dont le filtre passe-bas équivalent a plus de trois pôles, qui est centré sur la fréquence intermédiaire utilisée et dont la bande passante à 3 db est comprise entre 27 et 37 MHz.

## Patentansprüche

1. Zweistandard-Fernsehempfänger für entweder nach einem ersten Standard mit im Frequenzmultiplexbetrieb übertragenem Farbhilfsträger oder nach einem zweiten Standard, bei dem Signale im Zeitmultiplexbetrieb übertragen werden, frequenzmodulierte Signale mit einer Demodulatoreinrichtung, die ein dem eigentlichen Frequenzdemodulator vorgeschaltetes Bandpaßfilter mit abstimmbarer Mittelfrequenz umfaßt, die von der Eingangssignalfrequenz durch eine Rückkopplung steuerbar ist, durch die das vom Demodulator ausgegebene demodulierte Signal zum Abstimmregeleingang des Filters rückgekoppelt wird, was bei dem genannten ersten Standard über eine erste Schleife mit einem Tiefpaßfilter geschieht, die mit einer zweiten Schleife parallelgeschaltet ist, die ihrerseits ein praktisch auf die Frequenz des Farbhilfsträgers abgestimmtes Tiefpaßfilter umfaßt, wobei eine Addiereinrichtung vorgesehen ist, die von den beiden Schleifen gelieferten Signale addiert und dem Abstimmregeleingang des abstimmbaren Mittelfrequenzfilters zuführt, dadurch gekennzeichnet, daß das Tiefpaßfilter der ersten Schleife das einzige phasenverschobene Glied dieser Schleife ist und daß zur Anpassung des Fernsehers an den zweiten Standard die Einrichtung mit einem Ausschalter ausgestattet ist, mit dem die zweite Schleife außer Funktion gesetzt werden kann.

2. Fernsehempfänger nach Anspruch 1, dadurch gekennzeichnet, daß ein mit dem Bandpaßfilter, das praktisch auf die Frequenz des Farbhilfsträgers abgestimmt ist, in Reihe geschaltetes Hochpaßfilter vorgesehen ist.

3. Fernsehempfänger nach dem vorhergehenden Anspruch, dadurch gekennzeichnet, daß das Hochpaßfilter in der Nähe des Farbhilfsträgers eine Phasenverschiebung von 2 x pi x T x FSP bewirkt, wobei "FSP" die Hilfsträgerfrequenz und "T" die durch die Elemente der zweiten Schleife in die Schleife eingeführte Verzögerung ist.

4. Fernsehempfänger nach Anspruch 1, dadurch gekennzeichnet, daß das praktisch auf die Farbhilfsträgerfrequenz abgestimmte Bandpaßfilter genauer auf eine Frequenz abgestimmt ist, die eine leichte Verschiebung gegenüber der Farbhilfsträgerfrequenz aufweist, wobei die leichte Verschiebung derart gewählt ist, daß der PAL-Farbhilfsträgerfrequenz eine Phasenvoreilung entsprechend jener vermittelt wird, die durch ein in Reihe geschaltetes Hochpaßfilter erzeugt würde.

5. Fernsehempfänger nach einem der vorhergehenden Ansprüche, dadurch gekennzeichnet, daß das abstimmbare Mittelfrequenzfilter ein Äquivalenzfilter mit nur einem Pol aufweist, (ohne Modulation des Trägers) auf die verwendete Zwischenfrequenz zentriert ist und bei 3 dB eine Bandbreite zwischen 11 und 14 MHz hat.

6. Fernsehempfänger nach einem der vorhergehenden Ansprüche, dadurch gekennzeichnet, daß das Farbhilfsträgerfrequenz-Bandpaßfilter ein Äquivalenzfilter mit nur einem Pol aufweist, auf die Frequenz des Farbhilfsträgers zentriert ist und bei 3 dB eine Bandbreite zwischen 2 und 3 MHz hat.

7. Fernsehempfänger nach einem der vorhergehenden Ansprüche, dadurch gekennzeichnet, daß dem Bandpaßfilter mit abstimmbarer Mittelfrequenz ein weiteres festes Bandpaßfilter vorgeschaltet ist, dessen Äquivalenz-Bandpaßfilter mehr als drei Pole hat, das auf die verwendete Zwischenfrequenz zentriert ist und dessen Bandbreite bei 3 dB zwischen 27 und 37 MHz liegt.

## Claims

1. A bistandard television receiver for signals modulated in frequency in accordance with a first standard in which a chrominance subcarrier is multiplexed in frequency, or in accordance with a second standard in which the signals are temporally multiplexed, provided with a demodulator arrangement comprising upstream of said frequency demodulator a bandpass filter having a tunable central frequency which is controlled at the frequency of the input signal by means of a feedback returning the demodulated signal from the demodulator to the tuning control input of said filter, this being realised in the above-mentioned first standard via a first loop comprising a low-pass filter in parallel with a second loop comprising a bandpass filter substantially tuned to the frequency of the chrominance subcarrier, an adder for adding the signals from each one of the two loops and for applying them to the tuning control input of the filter having a tunable central frequency, characterized in that the low-pass filter of the first loop is the only phase-shifting element of said loop and in that, for adapting the television receiver to the above-mentioned second standard, the arrangement is provided with a switch for rendering the second loop inoperative.

2. A television receiver as claimed in Claim 1, characterized in that it comprises a high-pass filter in series with the bandpass filter which is substantially tuned to the frequency of the chrominance subcarrier.

3. A television receiver as claimed in the preceding Claim, characterized in that the high-pass filter brings about a phase shift of 2 x pi x T x FSP proximate to the chrominance subcarrier, where "FSP" is the frequency of the subcarrier and "T" is the delay introduced in the loop by the elements of the second loop.

4. A television receiver as claimed in Claim 1, characterized in that the bandpass filter substantially tuned to the frequency of the chrominance subcarrier is more precisely tuned to a frequency which has a minor phase shift with respect to the frequency of the chrominance subcarrier, said minor phase shift being such that it gives the frequency of the PAL chrominance subcarrier an advance phase shift which is equal to that which would be produced by a high-pass filter arranged in series.

5. A television receiver as claimed in any one of the preceding Claims, characterized in that the filter having a tunable central frequency includes an equivalent low-pass filter having a single pole, is centred at the used intermediate frequency (in the absence of modulation of the carrier) and has a passband at 3 dB between 11 and 14 MHz.

6. A television receiver as claimed in any one of the preceding Claims, characterized in that the bandpass filter having the frequency of the chrominance subcarrier includes an equivalent low-pass filter having a single pole, is centred at the frequency of the chrominance subcarrier and has a passband at 3 dB between 2 and 3 MHz.

7. A television receiver as claimed in any one of the preceding Claims, characterized in that it comprises upstream of the bandpass filter having a tunable central frequency a further fixed bandpass filter whose equivalent low-pass filter has more than three poles, is centred at the used intermediate frequency and has a passband at 3 dB between 27 and 37 MHz.
